# EUROPÄISCHE PATENTSCHRIFT

(11) **EP 1 166 276 B1**
(45) Veröffentlichungstag und Bekanntmachung des Hinweises auf die Patenterteilung: **04.12.2002**
(21) Anmeldenummer: 00925064.8
(22) Anmeldetag: 03.04.2000
(51) Int. Cl.: G11C 11/22

(54) **INTEGRIERTER FERROELEKTRISCHER SPEICHER, DESSEN PLATTENLEITUNGEN VOM SPALTENDECODER SELEKTIERT WERDEN**
INTEGRATED FERROELECTRIC MEMORY WHOSE PLATE LINES ARE SELECTED BY A COLUMN DECODER
MEMOIRE INTEGREE FERROELECTRIQUE DONT LES CONDUCTEURS PLATS SONT SELECTIONNES PAR UN DECODEUR DE COLONNES

(30) Priorität: 01.04.1999 DE 19915081
(43) Veröffentlichungstag der Anmeldung: 02.01.2002
(73) Patentinhaber: Infineon Technologies AG, 81669 München (DE)
(72) Erfinder: SCHLAGER, Tobias, A-8062 Kumberg (AT); HÖNIGSCHMID, Heinz, D-82319 Starnberg (DE)
(74) Vertreter: Kottmann, Heinz Dieter, Dipl.-Ing.
(86) Internationale Anmeldenummer: DE0000997
(87) Internationale Veröffentlichungsnummer: WO00060602

(56) Entgegenhaltungen:
- DE-A- 4 118 847

## Beschreibung

Die Erfindung betrifft einen integrierten Speicher, dessen Speicherzellen mit Plattenleitungen verbunden sind.

Aus der US 5,592,410 A ist ein ferroelektrischer Speicher in Form eines FRAM bzw. FeRAM (Ferroelectric Random Access Memory) beschrieben. Seine Speicherzellen weisen Auswahltransistoren und Speicherkondensatoren auf. Die Speicherkondensatoren weisen ein ferroelektrisches Dielektrikum auf, das in Abhängigkeit eines gespeicherten logischen Zustandes verschiedene Polarisationszustände einnehmen kann. Der Polarisationszustand beeinflußt die Kapazität des Speicherkondensators. Eine Elektrode jedes Speicherkondensators ist über den entsprechenden Auswahltransistor mit einer Bitleitung des Speichers verbunden. Ein Steueranschluß des Auswahltransistors ist mit einer Wortleitung des Speichers verbunden. Eine zweite Elektrode des Speicherkondensators ist mit einer Plattenleitung verbunden. Während eines Lesezugriffs wird der Auswahltransistor leitend geschaltet und das Potential der Plattenleitung von einem niedrigen auf ein hohes Potential gepulst. Die Veränderung des Potentials auf der mit der Speicherzelle verbundenen Bitleitung wird anschließend ausgewertet. Es ist ein Maß für die polarisationsabhängige Kapazität des Speicherkondensators und dient daher einer Feststellung des jeweils gespeicherten logischen Zustands.

In der US 5,592,410 A verlaufen die Wortleitungen senkrecht zu den Bitleitungen und die Plattenleitungen parallel zu den Wortleitungen. Jede Plattenleitung ist mit demselben Ausgang eines Wortdecoders verbunden, mit dem auch die zugehörige Wortleitung verbunden ist. Durch Aktivierung einer der Wortleitungen wird also auch immer gleichzeitig die zugehörige Plattenleitung aktiviert. Dies führt dazu, daß-alle-über die jeweils aktivierte Wortleitung selektierten Speicherzellen durch das gepulste Signal auf der mit ihnen verbundenen Plattenleitung das Potential auf der zugehörigen Bitleitung beeinflussen.

Aus der DE 41 18 847 ist ein integrierter Speicher gemäß dem Oberbegriff des Anspruchs 1 bekannt.

Der Erfindung liegt die Aufgabe zugrunde, einen integrierten Speicher anzugeben, der Speicherzellen mit Speicherkondensatoren aufweist, die mit Plattenleitungen verbunden sind, und bei dem bei Aktivierung einer Wortleitung nur das Potential auf einem Teil der Bitleitungen, die von der Wortleitung gekreuzt werden, durch gepulste Signale auf den Plattenleitungen beeinflußt wird.

Diese Aufgabe wird mit einem integrierten Speicher gemäß Patentanspruch 1 gelöst. Vorteilhafte Aus- und Weiterbildungen der Erfindung sind Gegenstand der abhängigen Patentansprüche.

Erfindungsgemäß sind die Plattenleitungen, die mit den Speicherkondensatoren der Speicherzellen verbunden sind, parallel zu den Bitleitungen angeordnet. Jeweils eine der Plattenleitungen und wenigstens eine der Bitleitungen sind mit denselben Speicherzellen verbunden. Ein Spaltendecoder dient der Auswahl einer der Plattenleitungen in Abhängigkeit einer anliegenden Spaltenadresse.

Während also in der US 5,592,410 A die Plattenleitungen parallel zu den Wortleitungen verlaufen und mit Ausgängen des Wortleitungsdecoders verbunden sind, verlaufen die Plattenleitungen bei der Erfindung parallel zu den Bitleitungen und werden durch den Spaltendecoder angesteuert. Dadurch, daß jede Plattenleitung mit den Speicherzellen der zugehörigen Bitleitung verbunden ist, wird erreicht, daß nur diejenige Speicherzellen von den gepulsten Signalen der Plattenleitung betroffen werden, deren zugehörige Bitleitung für den jeweiligen Speicherzugriff benötigt wird. Daher wird nur das Potential derjenigen Bitleitung durch gepulste Signale auf der zugehörigen Plattenleitungen beeinflußt, die gerade für eine Datenübertragung benötigt wird.

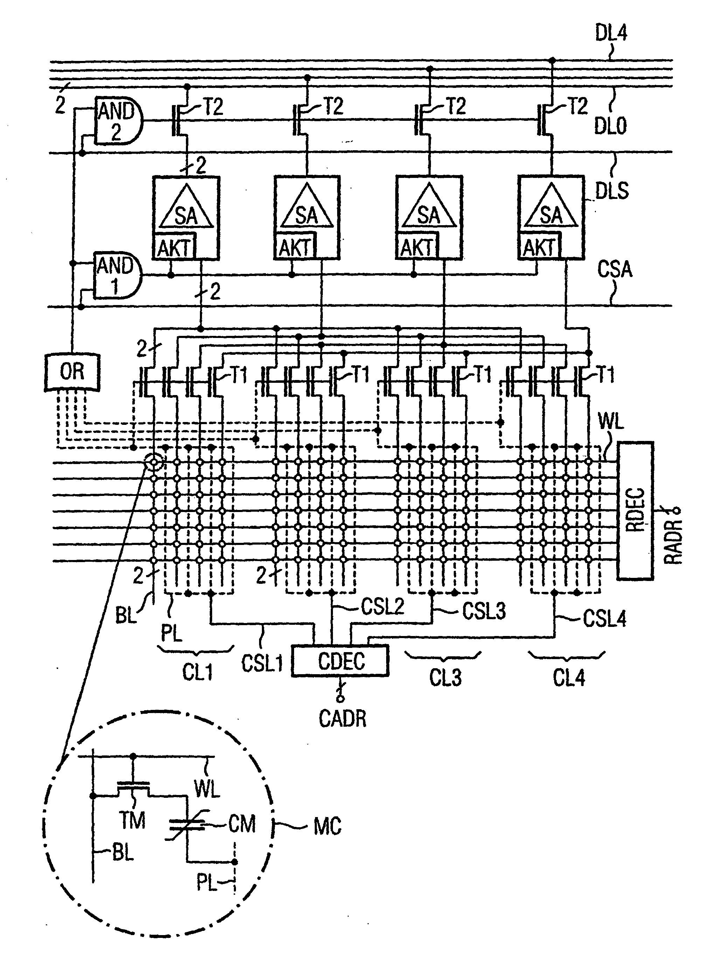

Die Erfindung wird im folgenden anhand eines in der Figur dargestellten Ausführungsbeispiels erläutert.

Die Figur zeigt ein FRAM mit Speicherzellen MC vom Ein-Transistor/Ein-Kondensator-Typ. Die Speicherzellen MC sind in Kreuzungspunkten von Bitleitungen BL und Wortleitungen WL angeordnet. Die Bitleitungen BL und Wortleitungen WL verlaufen senkrecht zueinander. Der Speicher weist eine Vielzahl von Plattenleitungen PL auf, die parallel zu den Bitleitungen BL angeordnet sind. Die Bitleitungen sind zu Bitleitungspaaren zusammengefaßt. Vereinfachend wurden in der Figur nur jeweils eine Bitleitung BL jedes Bitleitungspaares dargestellt. In Wirklichkeit wird bei Auswahl einer der Bitleitungen BL immer gleichzeitig auch eine komplementäre Bitleitung ausgewählt, die bei einem Lesezugriff auf eine der Speicherzellen MC ein entsprechendes Referenzsignal liefert.

Eine Speicherzelle MC ist in der Figur vergrößert dargestellt. Sie weist einen Auswahltransistor TM und einen Speicherkondensator CM auf. Der Speicherkondensator CM weist ein ferroelektrisches Dielektrikum auf. Seine eine Elektrode ist über den Auswahltransistor TM mit der zugehörigen Bitleitung BL verbunden. Seine andere Elektrode ist mit einer der Plattenleitungen PL verbunden. Das Gate des Auswahltransistors TM ist mit einer der Wortleitungen WL verbunden.

Die Bitleitungen BL sind über je einen ersten n-Kanal-Transistor T1 mit einem zugehörigen differentiellen Leseverstärker SA verbunden. Insgesamt zeigt die Figur vier Leseverstärker SA, denen jeweils vier Bitleitungspaare BL zugeordnet sind. Jeder Leseverstärker SA ist über zwei zweite Transistoren T2 mit einem Paar von Datenleitungen DLi verbunden. Bei einem Schreibzugriff werden Daten über die Datenleitungen DLi zu den Leseverstärkern SA und von diesen über die Bitleitungen BL zu den Speicherzellen MC übertragen. Bei einem Lesezugriff erfolgt eine Datenübertragung in die umgekehrte Richtung, wobei die Leseverstärker zum Verstärken des sich beim Auslesen einstellenden Differenzsignals auf dem jeweiligen Bitleitungspaar dienen.

Jeweils vier der Bitleitungspaare BL sind zu je einer Spalte CLi zusammengefaßt. Die Figur zeigt insgesamt vier Spalten CLi. Bei einem Zugriff auf die Speicherzellen MC ist nur jeweils eine der Spalten CLi ausgewählt, so daß beispielsweise bei einem Lesezugriff die Leseverstärker SA nur zum Verstärken von von dieser Spalte CLi gelieferten Daten dienen.

Die Wortleitungen sind mit Ausgängen eines Zeilendecoders RDEC verbunden, dem Zeilenadressen RADR zuführbar sind. Der Zeilendecoder wählt eine der Wortleitungen WL in Abhängigkeit der jeweils anliegenden Zeilenadresse RADR aus.

Jedem der Bitleitungspaare BL ist eine der Plattenleitungen PL zugeordnet. Die Plattenleitungen PL sind in der Figur gestrichelt dargestellt. Die vier Plattenleitungen PL jeder Spalte CLi sind elektrisch miteinander verbunden.. Sie sind über jeweils eine Spaltenauswahlleitung CSLi mit Ausgängen eines Spaltendecoders CDEC verbunden. Dem Spaltendecoder CDEC sind Spaltenadressen CADR zuführbar. In Abhängigkeit der zugeführten Spaltenadressen CADR wählt der Spaltendecoder CDEC eine der Spaltenauswahlleitungen CSLi aus. Auf dieser ausgewählten Spaltenleitung CSLi erzeugt der Spaltendecoder CDEC die für einen Lesezugriff oder Schreibzugriff auf die Speicherzellen erforderlichen gepulsten Signale für die mit der jeweiligen Spaltenauswahlleitung CSLi verbundenen Plattenleitungen PL. Die gepulsten Signal können beispielsweise den in der US 5,592,410 A gezeigten Verlauf haben.

Die vier Plattenleitungen PL jeder Spalte CLi sind an ihrem vom Spaltendecoder abgewandten Ende mit den Steueranschlüssen der der jeweiligen Spalte CLi zugeordneten ersten Transistoren T1 verbunden. Somit sind die Ausgänge des Spaltendecoders CDEC über die Plattenleitungen PL mit den Steueranschlüssen der ersten Transistoren T1 verbunden.

Die Figur zeigt außerdem ein ODER-Gatter OR mit vier Eingängen. Jeder dieser Eingänge ist mit den vier Plattenleitungen PL jeder Spalte CLi verbunden. Der Ausgang des ODER-Gatters OR ist mit dem ersten Eingang eines ersten UND-Gatters AND1 verbunden, dessen Ausgang mit einer Aktivierungseinheit AKT jedes Leseverstärkers SA verbunden ist. Ein zweiter Eingang des ersten UND-Gatters AND1 ist mit einer Aktivierungsleitung CSA verbunden. Die Aktivierungseinheiten AKT dienen zur Aktivierung des jeweiligen Leseverstärkers SA, wenn ihnen ein hoher Pegel zugeführt wird. Dies ist der Fall, wenn sowohl das Aktivierungssignal CSA als auch der Ausgang des ODER-Gatters OR einen hohen Pegel aufweisen.

Der Ausgang des ODER-Gatters OR ist außerdem mit einem ersten Eingang eines zweiten UND-Gatters AND2 verbunden, dessen Ausgang mit den Steueranschlüssen der zweiten Transistoren T2 verbunden ist. Ein zweiter Eingang des zweiten UND-Gatters AND2 ist mit einer Auswahlleitung DLS verbunden. Die zweiten Transistoren T2 werden über das zweite UND-Gatter AND2 leitend geschaltet, wenn sowohl das Auswahlsignal DLS als auch das Ausgangssignal des ODER-Gatters OR einen hohen Pegel aufweisen.

Die Plattenleitungen PL haben im nicht selektierten Zustand einen niedrigen Pegel. Bei einem Lesezugriff auf die Speicherzellen MC einer der Spalten CLi wählt der Spaltendecoder CDEC in Abhängigkeit der an ihm anliegenden Spaltenadresse CADR die entsprechende Spaltenauswahlleitung CSLi aus. Er überträgt über diese Spaltenauswahlleitung CSLi die für das Auslesen erfoderlichen gepulsten Signale zu den vier Plattenleitungen PL der ausgewählten Spalte CLi. Über diese gepulsten Signale werden einerseits die acht dieser Spalte CLi zugeordneten ersten Transistoren T1 leitend geschaltet. Gleichzeitig treten am Ausgang des ODER-Gatters OR ebenfalls gepulste Signale auf. Die Aktivierungsleitung CSA und die Auswahlleitung DLS nehmen einen hohen Pegel an. Daher werden die vier Leseverstärker SA über das erste UND-Gatter AND1 und ihre Aktivierungseinheiten AKT durch das Ausgangssignal des ODER-Gatters OR aktiviert, indem sie beispielsweise mit einem Versorgungspotential der integrierten Schaltung verbunden werden. Das Ausgangssignal des ODER-Gatters OR wird über das zweite UND-Gatter AND2 auch den Steueranschlüssen der zweiten Transistoren T2 zugeführt, so daß auch diese im Takt der gepulsten Signale leitend geschaltet werden.

Bei diesem Ausführungsbeispiel dient der Spaltendecoder CDEC also sowohl der Auswahl der Plattenleitungen PL, als auch der Aktivierung der ersten Transistoren T1 einer der Spalten CLi, der vier Leseverstärker SA sowie der mit diesen verbundenen acht zweiten Transistoren T2. Bei anderen Ausführungsbeispielen der Erfindung kann auch nur eines oder zwei der drei genannten Elemente über die Plattenleitungen PL mit dem Spaltendecoder CDEC verbunden sein.

Das ODER-Gatter OR ist notwendig, da bei diesem Ausführungsbeispiel die Leseverstärker SA im Multiplex zum Verstärken von aus den vier verschiedenen Spalten CLi gelieferten Daten dienen. Sie müssen also jedes Mal aktiviert werden, wenn nur eine der Spalten CLi durch den Spaltendecoder CDEC selektiert wird.

Die Figur zeigt lediglich einen Ausschnitt eines größeren Speichers, der mehrere Gruppen von je vier Leseverstärkern SA mit den zugehörigen ersten Transistoren T1 und zweiten Transistoren T2 sowie den angeschlossenen Speicherzellen MC aufweist. Alle diese Gruppen sind über ihre acht zweiten Transistoren T2 mit denselben vier Datenleitungspaaren DLi verbunden. Allerdings wird über den Spaltendecoder CDEC nur jeweils eine Spalte CLi in einer der Leseverstärkergruppen ausgewählt, so daß nur aus dieser selektierten Spalte CLi bei einem Lesezugriff vier Datenbits über die zugehörigen Leseverstärker SA zu den Datenleitungspaaren CLi übertragen werden. Während also jeder Spalte CLi eine unterschiedliche Spaltenadresse CADR zugeordnet ist, sind die Aktivierungsleitung CSA und die Auswahlleitung DLS allen Leseverstärkergruppen gemeinsam.

## Patentansprüche

1. Integrierter Speicher
- mit Speicherzellen (MC), die in Kreuzungspunkten von Bitleitungen (BL) und Wortleitungen (WL) angeordnet sind und jeweils mindestens einen Auswahltransistor (TM) und einen Speicherkondensator (CM) aufweisen,
- bei dem ein Steueranschluß der Auswahltransistoren (TM) mit einer der Wortleitungen (WL) verbunden ist und jeder Auswahltransistor eine Elektrode des zugehörigen Speicherkondensators (CM) mit einer der Bitleitungen (BL) verbindet,
- mit Plattenleitungen (PL) zum Führen gepulster Signale, die mit einer vom jeweiligen Auswahltransistor (TM) abgewandten Elektrode der Speicherkondensatoren (CM) verbunden sind,
- mit einem Zeilendecoder (REDEC) zur Adressierung der Wortleitungen (WL) und
- mit einem Spaltendecoder (CDEC),
- bei dem die Plattenleitungen (PL) parallel zu den Bitleitungen (BL) angeordnet sind,
- bei dem jeweils eine der Plattenleitungen (PL) und wenigstens eine der Bitleitungen (BL) mit denselben Speicherzellen (MC) verbunden sind,
- bei dem der Spaltendecoder (CDEC) zur Auswahl wenigstens einer der Plattenleitungen (PL) in Abhängigkeit einer anliegenden Spaltenadresse (CADR) dient,
- bei dem Leseverstärker (SA) zum Verstärken von aus den Speicherzellen (MC) ausgelesenen Daten mit jeweils wenigstens einer der Bitleitungen (BL) verbunden sind, und
- bei dem Steuereinheiten (T1, T2, AKT) erste und zweite Schaltelemente (T1) sind und den Leseverstärkern (SA) Eingangssignale liefern oder deren Ausgangssignale weiterleiten oder diese in Betrieb setzen,
**dadurch gekennzeichnet,**
- **daß** die Leseverstärker (SA) mit jeweils wenigstens zwei der Bitleitungen (BL) verbunden sind, denen unterschiedliche Spaltenadressen (CADR) zugeordnet sind, wobei die Leseverstärker (SA) über jeweils eines der ersten Schaltelemente (T1) an eine der Bitleitungen (BL) angeschlossen sind,
- **daß** ein Steueranschluß jedes ersten Schaltelements (T1) mit dem Spaltendecoder (CDEC) verbunden ist,
- **daß** Datenleitungen (DLi) zum Übertragen von durch die Leseverstärker (SA) verstärkten, aus den Speicherzellen (MC) ausgelesenen Daten über die zweiten Schaltelemente (T2) mit den Leseverstärkern (SA) verbunden sind, und
- **daß** diejenigen Plattenleitungen (PL), die den mit dem jeweiligen Leseverstärker (SA) verbundenen Bitleitungen (BL) zugeordnet sind, über eine ODER-Verknüpfung (OR) mit dem Steueranschluß des mit dem jeweiligen Leseverstärker (SA) verbundenen zweiten Schaltelementes (T2) verbunden sind.

2. Integrierter Speicher nach Anspruch 1, **dadurch gekennzeichnet, daß** der Steueranschluß jedes ersten Schaltelements (T1) mit einem der Ausgänge des Spaltendecoders (CDEC) über diejenige Plattenleitung (PL) verbunden ist, die der mit dem jeweiligen ersten Schaltelement (T1) verbundenen Bitleitung (BL) zugeordnet ist.

3. Integrierter Speicher nach Anspruch 1 oder 2,
**dadurch gekennzeichnet,**
- **daß** die Steuereinheiten Aktivierungseinheiten (AKT) enthalten, die jeweils einem der Leseverstärker (SA) zugeordnet sind und die einen Aktivierungseingang zur Aktivierung des jeweiligen Leseverstärkers (SA) aufweisen, und
- **daß** der Aktivierungseingang der Aktivierungseinheit (AKT) jedes Leseverstärkers (SA) mit einem der Ausgänge des Spaltendecoders (CDEC) über diejenige Plattenleitung (pL) verbunden ist, die der mit dem jeweiligen Leseverstärker verbundenen Bitleitung (BL) zugeordnet ist.

4. Integrierter Speicher nach Anspruch 3,
**dadurch gekennzeichnet,**
- **daß** diejenigen Plattenleitungen (PL), die den mit dem jeweiligen Leseverstärker (SA) verbundenen. Bitleitungen (BL) zugeordnet sind, über eine ODER-Verknüpfung (OR) mit dem Aktivierungseingang des jeweiligen Leseverstärkers (SA) verbunden sind.

5. Integrierter Speicher nach einem der Ansprüche 1 bis 4,
**dadurch gekennzeichnet,**
- **daß** die Steuereinheiten zweite Schaltelemente (T2) sind,
- **daß** ein Steueranschluß jedes zweiten Schaltelements (T2) mit einem der Ausgänge des Spaltendecoders (CDEC) über diejenige Plattenleitung (PL) verbunden ist, die der mit dem jeweiligen Leseverstärker (SA) verbundenen Bitleitung (BL) zugeordnet ist.

6. Integrierter Speicher nach einem der Ansprüche 1 bis 5,
**dadurch gekennzeichnet,**
**daß** dieser ein ferroelektrischer Speicher ist, dessen Speicherkondensator (CM) ein ferroelektrisches Dielektrikum aufweist.

## Claims

1. Integrated memory
- having memory cells (MC), which are arranged at crossover points between bit lines (BL) and word lines (WL) and each have at least one selection transistor (TM) and a storage capacitor (CM),
- in which a control terminal of the selection transistors (TM) is connected to one of the word lines (WL) and each selection transistor connects an electrode of the associated storage capacitor (CM) to one of the bit lines (BL),
- having plate lines (PL) for carrying pulsed signals, which are connected to an electrode of the storage capacitors (CM) which is remote from the respective selection transistor (TM),
- having a row decoder (REDEC) [sic] for addressing the word lines (WL), and
- having a column decoder (CDEC),
- in which the plate lines (PL) are arranged parallel to the bit lines (BL),
- in which a respective one of the plate lines (PL) and at least one of the bit lines (BL) are connected to the same memory cells (MC),
- in which the column decoder (CDEC) serves for selecting at least one of the plate lines (PL) in a manner dependent on a column address (CADR) that is present,
- in which sense amplifiers (SA) for amplifying data read from the memory cells (MC) are connected to in each case at least one of the bit lines (BL), and
- in which control units (T1, T2, AKT) are first and second switching elements (T1) and supply input signals to the sense amplifiers (SA) or forward the output signals thereof or activate them,
**characterized**
- **in that** the sense amplifiers (SA) are connected to in each case at least two of the bit lines (BL) which are assigned different column addresses (CADR), the sense amplifiers (SA) being connected to one of the bit lines (BL) via a respective one of the first switching elements (T1),
- **in that** a control terminal of each first switching element (T1) is connected to the column decoder (CDEC),
- **in that** data lines (DLi) for transferring data that have been read from the memory cells (MC) and amplified by the sense amplifiers (SA) are connected to the sense amplifiers (SA) via the second switching elements (T2), and
- **in that** those plate lines (PL) which are assigned to the bit lines (BL) connected to the respective sense amplifier (SA) are connected via an OR function (OR) to the control terminal of the second switching element (T2) connected to the respective sense amplifier (SA).

2. Integrated memory according to Claim 1,
**characterized in that** the control terminal of each first switching element (T1) is connected to one of the outputs of the column decoder (CDEC) via that plate line (PL) which is assigned to the bit line (BL) connected to the respective first switching element (T1).

3. Integrated memory according to Claim 1 or 2,
**characterized**
- **in that** the control units contain activation units (AKT) which are each assigned to one of the sense amplifiers (SA) and have an activation input for activation of the respective sense amplifier (SA), and
- **in that** the activation input of the activation unit (AKT) of each sense amplifier (SA) is connected to one of the outputs of the column decoder (CDEC) via that plate line (PL) which is assigned to the bit line (BL) connected to the respective sense amplifier.

4. Integrated memory according to Claim 3,
**characterized**
- **in that** those plate lines (PL) which are assigned to the bit lines (BL) connected to the respective sense amplifier (SA) are connected via an OR function (OR) to the activation input of the respective sense amplifier (SA).

5. Integrated memory according to one of Claims 1 to 4,
**characterized**
- **in that** the control units are second switching elements (T2),
- **in that** a control terminal of each second switching element (T2) is connected to one of the outputs of the column decoder (CDEC) via that plate line (PL) which is assigned to the bit line (BL) connected to the respective sense amplifier (SA).

6. Integrated memory according to one of Claims 1 to 5,
**characterized**
**in that** it is a ferroelectric memory whose storage capacitor (CM) has a ferroelectric dielectric.

## Revendications

1. Mémoire intégrée
- comprenant des cellules (MC) de mémoire qui sont disposées aux points d'intersection de lignes (BL) de bit et de lignes (WL) de mots et qui ont respectivement au moins un transistor (TM) de sélection et un condensateur (CM) de mémoire,
- dans laquelle une home de commande des transistors (TM) de sélection est reliée à l'une des lignes (WL) de mots et chaque transistor de sélection relie une électrode du condensateur (CM) de mémoire associé à l'une des lignes (BL) de bits,
- comprenant des lignes (PL) de plaque pour le passage de signaux pulsés, qui sont reliés à une électrode des condensateurs (CM) de mémoire, qui est éloignée du transistor (TM) respectif de sélection,
- comprenant un décodeur (REDEC) de ligne pour l'adressage des lignes (WL) de mots et,
- comprenant un décodeur (CDEC) de colonne,
- dans lequel les lignes (PL) de plaque sont disposées parallèlement aux lignes (BL) de bits,
- dans laquelle respectivement l'une des lignes (PL) de plaque et au moins l'une des lignes (BL) de bits sont reliées aux mêmes cellules (LC) de la mémoire,
- dans laquelle le décodeur (CDEC) de colonne sert à sélectionner au moins l'une des lignes (PL) de plaque en fonction d'une adresse (CADR) de colonne qui y est appliquée,
- dans laquelle des amplificateurs (SA) de lecture destinés à amplifier des données lues dans les cellules (MC) de mémoire sont reliés à respectivement au moins l'une des lignes (BL) de bits, et
- dans laquelle des unités (T1, T2, AKT) de commande sont des premier et deuxième éléments (T1) de commutation et envoient aux amplificateurs (SA) de lecture des signaux d'entrée ou transmettent leurs signaux de sortie ou les mettent en service,
**caractérisée,**
- **en ce que** les amplificateurs (SA) de lecture sont reliés à respectivement au moins deux des lignes (BL) de bits, auxquelles sont associées des adresses (CADR) différentes de colonne, les amplificateurs (SA) de lecture étant raccordés à l'une des lignes (BL) de bits par respectivement l'un des premiers éléments (T1) de commutation,
- **en ce qu'**une borne de commande de chaque premier élément (T1) de commutation est reliée au décodeur (CDEC) de colonne,
- **en ce que** des lignes (DLi) de données, destinées à transmettre des données amplifiées par les amplificateurs (SA) de lecture et lues dans les cellules (MC) de mémoire, sont reliées aux amplificateurs (SA) de lecture par les deuxièmes éléments (T2) de commutation, et
- **en ce que** les lignes (PL) de plaque, qui sont associées aux lignes (BL) de bits reliées à l'amplificateur (SA) respectif de lecture, sont reliées par un élément (OR) logique OU à la borne de commande du deuxième élément (T2) de commutation relié à l'amplificateur (SA) respectif de lecture.

2. Mémoire intégrée suivant la revendication 1, **caractérisée en ce que** la borne de commande de chaque premier élément (T1) de commutation est reliée à l'une des sorties du décodeur (CDEC) de colonne par la ligne (PL) de plaque qui est associée à la ligne (BL) de bits reliée au, respectivement, premier élément (T1) de commutation.

3. Mémoire intégrée suivant la revendication 1 ou 2, **caractérisée**
- **en ce que** les unités de commande comportent des unités (AKT) d'activation qui sont associées respectivement à l'un des amplificateurs (SA) de lecture et qui ont une entrée d'activation pour l'activation de l'amplificateur (SA) respectif de lecture, et
- **en ce que** l'entrée d'activation de l'unité (AKT) d'activation de chaque amplificateur (SA) de lecture est reliée à l'une des sorties du décodeur (CDEC) de colonne par la ligne (PL) de plaque qui est associée à la ligne (BL) de bits reliée à l'amplificateur respectif de lecture.

4. Mémoire intégrée suivant la revendication 3, **caractérisée**
- **en ce que** les lignes (PL) de plaque qui sont associées aux lignes (BL) de bits reliées à l'amplificateur (SA) respectif de lecture sont reliées à l'entrée d'activation de l'amplificateur (SA) respectif de lecture par un élément (OR) logique OU.

5. Mémoire intégrée suivant l'une des revendications 1 à 4,
- en ce que les unités de commande sont des deuxièmes éléments (T2) de commutation,
- en ce qu'une borne de commande de chaque deuxième élément (T2) de commutation est reliée à l'une des sorties du décodeur (CDEC) de colonne par la ligne (PL) de plaque qui est associée à la ligne (BL) de bits reliée à l'amplificateur (SA) respectif de lecture.

6. Mémoire intégrée suivant l'une des revendications 1 à 5,
**caractérisée**
- **en ce que** c'est une mémoire ferroélectrique dont le condensateur (CM) de mémoire a un diélectrique ferroélectrique.
